Europäisches Patentamt

European Patent Office

Office européen des brevets

(19)

(11) EP 0 969 509 A1

## (12) DEMANDE DE BREVET EUROPEEN

(43) Date de publication:
05.01.2000 Bulletin 2000/01

(51) Int Cl.⁷: **H01L 23/64**, H01L 23/66

(21) Numéro de dépôt: 99420135.8

(22) Date de dépôt: 15.06.1999

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **29.06.1998 FR 9808434**

(71) Demandeur: **Memscap**
**38330 Saint Ismier (FR)**

(72) Inventeur: **Karam, Jean-Michel**
**38000 Grenoble (FR)**

(74) Mandataire: **Palix, Stéphane (FR) et al**
**Cabinet Laurent et Charras**
**20, rue Louis Chirpaz**
**B.P. 32**
**69131 Ecully Cedex (FR)**

(54) **Circuit integre monolithique comprenant une inductance plane ou un transformateur plan, et procédé de fabrication d'un tel circuit**

(57) Circuit intégré monolithique, notamment destiné à être incorporé dans un circuit de radio-fréquence, comprenant :

- une couche de substrat (6) en matériau semi-conducteur;
- une inductance plane (1) formée d'un ruban métallique enroulé en spirale,

caractérisé en ce que chaque spire (2 - 5) de l'inductance (1) est séparée :

- des spires voisines par une couche d'air (10);
- et de la couche de substrat par une couche d'air (15).

FIG 2

EP 0 969 509 A1

**Description**

**Domaine Technique**

L'invention concerne le domaine de la micro-électronique et des micro-systèmes. Elle vise plus précisément des circuits intégrés monolithiques incorporant des inductances, tels qu'utilisés notamment dans le domaine des radiofréquences.

Elle vise plus précisément à obtenir des inductances présentant un meilleur facteur de qualité et assurant un fonctionnement des fréquences plus élevées qu'avec les inductances obtenues actuellement.

**Techniques antérieures**

Comme on le sait, les circuits intégrés sont de plus en plus utilisés dans les techniques des micro-ondes et des radiofréquences.

Dans ces applications, il est important de pouvoir utiliser des circuits résonnants accordés constitués par un ensemble capacité-inductance. Or, ces circuits doivent aujourd'hui être réalisés dans des volumes plus en plus réduits. En outre, ils doivent fonctionner à des fréquences de plus en plus élevées. Enfin, la consommation électrique de tels composants devient un paramètre critique, par exemple dans les téléphones portables cellulaires car cette consommation influe directement sur l'autonomie de ces appareils.

Ainsi, il est demandé aux composants passifs constituant les filtres utilisés dans des systèmes à radiofréquences, notamment les inductances, d'occuper une surface aussi faible que possible à l'intérieur des circuits intégrés, d'avoir une valeur de cette inductance aussi élevée que possible pour réduire la consommation électrique.

En outre, on sait que les inductances implantées à l'intérieur de circuits intégrés en matériau semi-conducteurs subissent l'influence de capacités parasites constituées par les différentes zones de substrats localisées au voisinage de l'inductance.

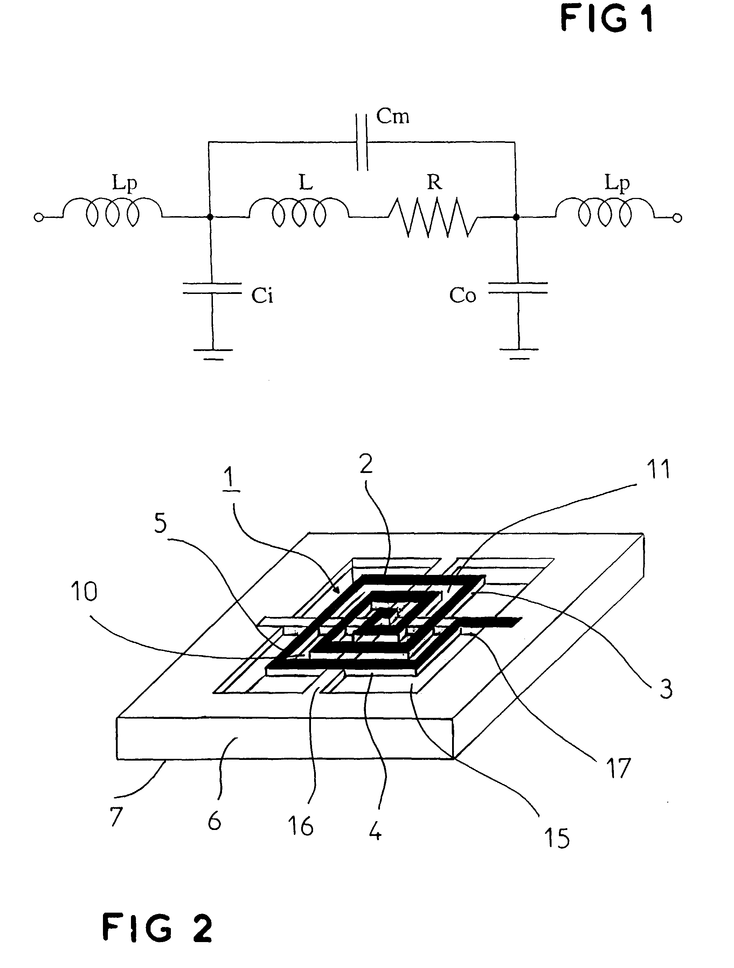

On a représenté en figure 1 un schéma électrique équivalent à une inductance implantée dans une puce de circuit intégré. Ainsi, une telle inductance présente un schéma équivalent dans lequel, à cette inductance proprement dite (L), s'ajoutent les différents composants parasites écartant cette inductance de son comportement idéal. Ainsi, une inductance présente une résistance (Rs) correspondant à celle du métal qui la compose. En outre, cette inductance présente différentes capacités ($C_i$ et $C_o$) qui sont des capacités parasites résultant de la présence du substrat semi-conducteur situé entre la zone métallique formant l'inductance elle-même et le plan de masse. En outre, ces régions de substrat présentent une certaine conductivité équivalente modélisée par des résistances ($G_i$ et $G_0$) illustrées à la figure 1.

On a proposé, notamment dans le document US 5 539 241 de diminuer l'influence des capacités parasites entre le bobinage formant inductance et le plan de masse en séparant le plan de masse et l'inductance par une couche d'air, dont la permittivité électrique est nettement inférieure à celle du substrat semi-conducteur. En pratique, la solution adoptée dans ce document consiste à disposer le bobinage formant inductance sur une pastille de substrat elle-même reliée au reste du substrat par quelques pontages très localisés.

Cette solution, si elle permet une certaine diminution de l'influence des capacités parasites ($C_i$ et $C_0$) par rapport au plan de masse, n'a aucune incidence sur la capacité parasite existant entre les différences spires constituant l'inductance, et qui est modélisée dans le schéma équivalent de la figure 1 par la capacité (Cs).

Un premier problème que se propose de résoudre l'invention est celui de la diminution de l'influence de la capacité parasite entre spires. En effet, la présence de cette capacité parasite est prédominante à haute fréquence, et au-delà d'une certaine fréquence, cette inductance ne remplit plus son rôle et ne peut pas être intégrée dans un filtre accordé.

De cette manière, on mesure la fréquence optimale de fonctionnement comme étant celle où le facteur de qualité est maximum. On rappelle que le facteur de qualité correspond au rapport entre la partie imaginaire (ou réactance) et la partie réelle de l'inductance d'entrée correspondant au modèle de l'inductance montrée en figure 1.

**Exposé de l'invention**

L'invention concerne donc un circuit intégré, notamment destiné à être incorporé dans un circuit radiofréquence, comprenant :

- une couche de substrat en matériau semi-conducteur ;
- une inductance plane formée d'un ruban métallique enroulé en spirale.

Ce circuit se caractérise en ce que chaque spire de l'inductance est à la fois séparée :

- des spires voisines par une couche d'air ;
- et de la couche du substrat, également par une couche d'air.

Ainsi, l'invention consiste à éliminer au maximum tout pontage diélectrique entre les spires pour diminuer ainsi la valeur de la capacité parasite existant entre spires. En d'autres termes, il s'agit donc de suspendre quasi complètement la structure métallique en spirale pour l'isoler complètement du substrat relié au plan de masse.

Par cette suspension complète, on élimine la présence de tout diélectrique entre les spires, et la capacité parasite correspondant à la capacité (Cs) du modèle illustré à la figure 1 est grandement diminuée.

En pratique, le ruban métallique enroulé en spirale est constitué d'une succession de segments rectilignes. De la sorte, on facilite la fabrication en utilisant des formes géométriques simples, faciles à réaliser.

En outre, l'utilisation de segments rectilignes, et avantageusement configurés en carré, ne fait intervenir des phénomènes de couplage magnétique qu'entre les segments des spires qui sont parallèles entre eux, le couplage entre les segments perpendiculaires entre eux étant négligeable.

Pour résoudre le problème de la compacité de l'inductance, chaque spire est éloignée des spires voisines d'une distance inférieure à 15 micromètres. De la sorte, on obtient une inductance de superficie limitée, qui présente un fort coefficient de self inductance. Cela nécessite donc de réaliser, lors du processus de fonderie, des ouvertures de faible dimension entre les spires, nettement inférieures aux dimensions actuellement accessibles sur les procédés traditionnels.

Selon l'invention, on permet donc, une diminution de la capacité parasite tout en augmentant la valeur de l'inductance proprement dite.

En pratique, on peut utiliser comme matériau semi-conducteur formant le substrat différents types de semi-conducteurs tels que le silicium, l'arséniure de gallium (AsGa), le carbure de silicium (SiC) ou le phosphure d'indium (InP).

On notera qu'en utilisant la technique de fabrication connue sous l'abréviation HEMT signifiant "High Electron Mobility Transistor" avec un substrat réalisé en arséniure de gallium (AsGa), on peut réaliser des inductances dont les spires sont distantes chacune de 4 micromètres tout en permettant, lors du procédé de fabrication, l'élimination du substrat présent entre les spires.

En pratique, l'inductance repose sur deux poutres de matériau semi-conducteurs traversant une cavité creusée dans la couche de substrat, sous l'inductance proprement dite. De la sorte, l'inductance est suspendue au-dessus de cette cavité et ne repose que sur deux zones de très faibles dimensions

Dans une forme plus perfectionnée de l'invention, le circuit intégré comprend une seconde inductance plane enroulée en spirale entre les spires de la première inductance de manière à ce que les inductances soient couplées pour former un transformateur, les spires des deux inductances étant séparées les unes des autres par une couche d'air.

Ainsi, de la même manière, on réalise un transformateur dont la capacité parasite entre les deux enroulements est extrêmement faible, en tout cas nettement inférieure à celle du transformateur décrit dans les documents US 5 539 241, EP 0 413 348, WO 87/07074, GB 2 173 956.

Il s'ensuit qu'un tel transformateur peut être utilisé dans des montages fonctionnant à beaucoup plus haute fréquence que les montages existants.

L'invention concerne également un procédé pour réaliser un circuit intégré tel que décrit précédemment qui se <u>caractérise</u> en ce qu'il consiste :

- à former sur un substrat semi-conducteur, une couche d'oxydation ;
- à déposer une couche de métallisation sur ladite couche d'oxydation pour former au moins un ruban en spirale destiné à constituer une inductance ;
- à réaliser des ouvertures dans la couche d'oxydation entre les spires du ruban ;
- à graver le substrat dans lesdites zones d'ouvertures par attaque chimique de manière à réaliser une cavité sous le ruban en spirale, et à isoler les spires du ruban les unes des autres.

**Description sommaire des figures**

La manière de réaliser l'invention, ainsi que les avantages qui en découlent ressortiront bien de la description des modes de réalisation qui suivent, à l'appui des figures annexées dans lesquelles :

La figure 1 est un schéma électrique représentant la modélisation électrique d'un segment d'une inductance réalisée dans un circuit intégré.

La figure 2 est une vue en perspective sommaire d'une inductance réalisée conformément à l'invention.

La figure 3 est un schéma électrique illustrant le comportement d'une inductance réalisée conformément à l'invention à partir de segments rectilignes.

La figure 4 est un graphique illustrant les valeurs de capacité parasite exprimées par unité de longueur, et ce pour différentes valeurs d'espacement de l'inductance conforme à l'invention par rapport au substrat.

La figure 5 est un graphique illustrant l'impédance d'entrée de l'inductance conforme à l'invention, en fonction de la fréquence, et ce pour plusieurs valeurs de distance entre le plan de l'inductance et le substrat.

La figure 6 est un diagramme illustrant le facteur de qualité d'une inductance conforme à l'invention pour différentes valeurs de distance gérées entre le plan de l'inductance et le substrat.

La figure 7 est un diagramme montrant l'évolution du facteur de qualité en fonction de la fréquence, tel que mesuré pour différentes épaisseurs de couche d'air.

La figure 8 est un schéma illustrant, en vue de dessus, deux inductances conformes à l'invention couplées pour former un transformateur.

La figure 9 est un schéma électrique modélisant le comportement électrique du transformateur de la figure 8.

La figure 10 sont deux graphiques illustrant les variations des coefficients de réflexion et de transmission, en fonction de la fréquence, respectivement pour une inductance disposée directement sur le substrat, et une inductance distante du substrat.

## Manière de réaliser l'invention

Comme déjà dit, l'invention concerne des circuits intégrés monolithiques destinés à des applications radiofréquences et qui incorporent des inductances.

Conformément à l'invention, les inductances sont réalisées par un ruban métallique enroulé en forme de spirale, comme illustré à la figure 2.

Plus précisément, l'inductance (1) telle qu'illustrée à la figure 2 est constituée par un ruban constitué d'un ensemble de segments rectilignes (2-5), chaque segment étant perpendiculaire aux segments adjacents.

Bien évidemment, l'invention ne se limite pas à la forme de réalisation dans laquelle la spirale formant inductance s'inscrit dans un carré, mais couvre également les variantes de forme dans lesquelles le ruban est formé de segments s'inscrivant dans un polygone quelconque, ou bien alors adopte une forme curviligne.

Selon une caractéristique de l'invention, chaque spire (2-5) est séparée des spires adjacentes, par une couche d'air (10, 11). En d'autres termes, il n' y a pas de diélectrique présent entre chaque spire. De la sorte, l'interposition d'une couche d'air réduit fortement la permittivité moyenne du milieu inter-spires, car la permittivité diélectrique de l'air ($\varepsilon_r = 1$) est nettement inférieure à la permittivité relative des matériaux semi-conducteurs utilisés en tant que substrat, généralement supérieure à 5.

Ainsi, l'absence de tout matériau diélectrique entre les spires élimine les zones de transition de matériaux qui sont la source de pertes d'énergie du champ électrique.

Selon une autre caractéristique de l'invention, le ruban métallisé (1) formant l'inductance est séparé du substrat (6) lui-même relié au plan de masse (7) par une couche d'air (15) servant également à réduire au maximum la capacité parasite existant entre l'inductance (1) et le plan de masse (7), et modélisé dans le schéma de la figure 1 par les capacités $C_i$ et $C_0$.

En pratique, on peut réaliser des cavités en dessous de l'inductance proprement dite qui présentent des profondeurs comprises entre 5 et 100 micromètres, la capacité parasite résiduelle décroissant avec la profondeur de la cavité.

Dans ce cas, le bobinage de l'inductance (1) repose sur deux poutrelles (16, 17) traversant la cavité (15). Bien évidemment, pour limiter l'influence de ces poutrelles sur les capacités parasites, les dimensions de ces poutrelles (16, 17) sont réduites au maximum.

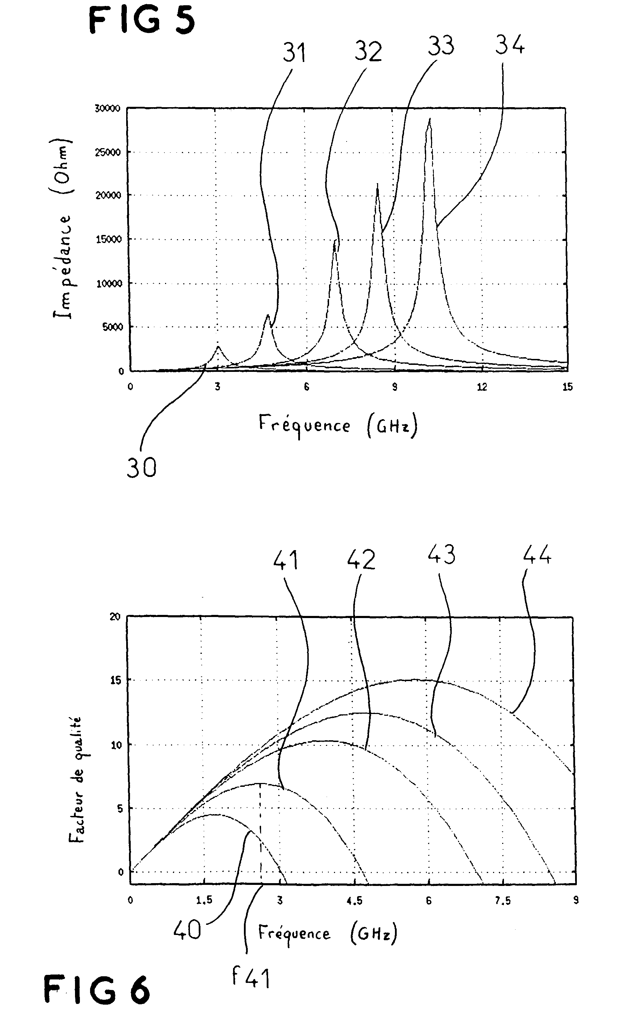

On a illustré en figure 4 la valeur de la capacité parasite totale, pour différentes valeurs d'épaisseur de cette couche d'air.

Ainsi, on remarque que dans le cas où l'inductance est directement disposée sur le substrat (courbe n° 20), la capacité par unité de longueur est voisine de 60 picoFarads par mètre (pF/m). Ces résultats sont obtenus pour une inductance réalisée selon la technologie HEMT sur un substrat en AsGa, pour une largeur de bande métallique de 9 micromètres et une distance entre bandes métalliques de 9 micromètres.

En revanche, lorsque conformément à l'invention, le bobinage inductif (1) est séparé du substrat par une couche d'air même minime, la valeur de la capacité parasite chute à une valeur de 3 à 6 fois inférieure pour atteindre des valeurs de 20 picoFarads par mètre pour une couche d'air de 8 micromètres (courbe 21), 15 pF/m pour une couche d'air de 22 micromètres (courbe 22) et 10 picoFarads par mètre pour une couche d'air de 36, 42 ou 45 micromètres d'épaisseur (courbe 23,24,25).

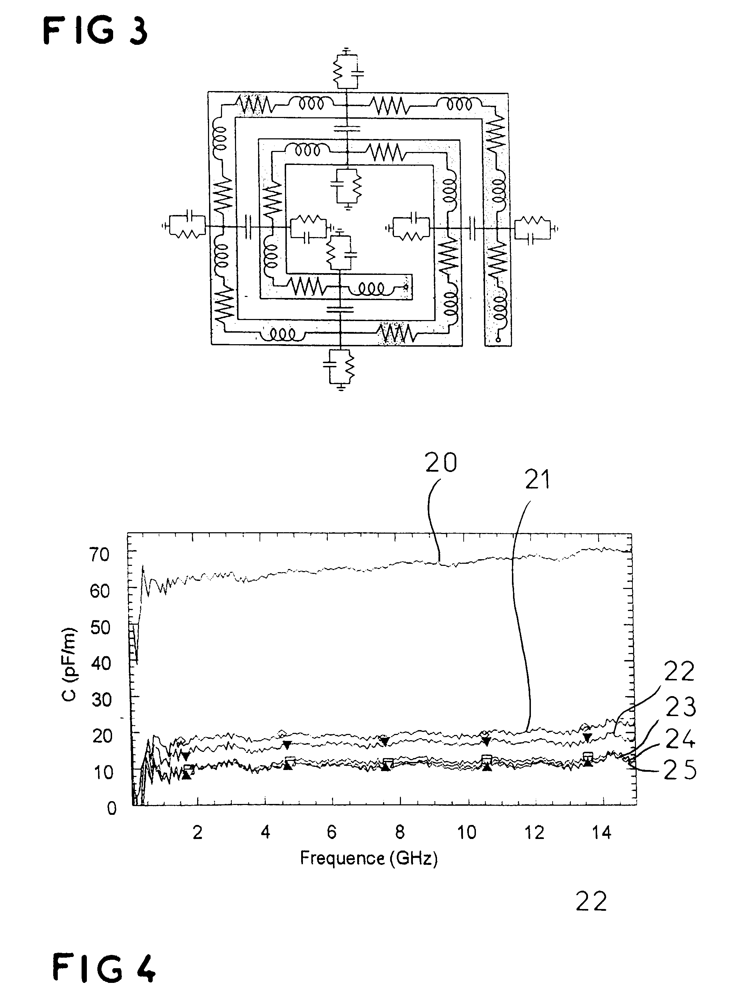

Compte tenu de la modélisation de chaque segment composant le ruban enroulé en spirale, l'inductance totale présente un schéma équivalent illustré à la figure 3.

On a représenté en figure 5 différentes courbes représentant l'impédance d'entrée d'une telle inductance, en fonction de la fréquence, pour différentes valeurs d'épaisseur de couche d'air située entre le substrat et l'inductance.

Plus précisément, ces courbes représentent la valeur de l'inductance d'entrée pour une inductance de 15 nH dont les différents composants selon le modèle de la figure 1 ont pour valeur :

- $R = 23,7\ \Omega$
- $L = 12,2\ nH$
- $L_p = 1,4\ nH$
- $C_i = 200\ fF$ (femto Farad);
- $C_0 = 144\ fF$
- $C_m = 2,2\ fF$

La courbe 30 représente l'impédance d'entrée mesurée pour une impédance reposant directement sur le substrat. On observe ainsi que l'impédance d'entrée est doublée lorsque l'on crée une couche d'air d'une épaisseur égale à 1 micromètre en dessous de la bobine (courbe 31). Cette impédance d'entrée est sensiblement multipliée par 4 lorsque cette couche d'air est d'une épaisseur voisine de 5 microns (courbe 32). Cette impédance est multipliée par respectivement 10 et 12 lorsque la couche d'air a un épaisseur de 50 et 100 micromètres (courbes 33 et 34)

Sur les mêmes courbes, on observe que la fréquence de résonance de l'inductance est augmentée de 60 % lorsque la couche d'air est de 1 micromètre (courbe 31).

Lorsque la couche d'air est d'une épaisseur de 5 micromètres (courbe 32), la fréquence de résonance est multipliée par environ 2,3 , par rapport à une structure dans laquelle l'inductance repose directement sur le substrat (courbe 30).

La figure 6 représente la valeur du facteur de qualité pour la même inductance, c'est-à-dire représentée par les mêmes composants du modèle équivalent.

On observe ainsi que le maximum du facteur de qualité est augmenté de 50 % lorsque la bobine est séparée du substrat par une épaisseur d'air de micromètre (courbe 41) par rapport à la configuration dans laquelle l'inductance repose sur le substrat (courbe 40). Ce maximum est plus que doublé lorsque l'épaisseur de la couche d'air atteint 5 micromètres (courbe 42). Il est multiplié respectivement par 2,5 et 3 lorsque la couche d'air a une épaisseur de 50 et 100 micromètres (courbes 43 et 44)

Corrélativement, la valeur de fréquence (f41) correspondant au maximum du facteur de qualité est également augmentée sensiblement de 50 % lorsque la couche d'air située sous l'inductance atteint une valeur d'un micromètre (courbe 41), et elle est multipliée par environ 2 lorsque la couche d'air a une épaisseur de 5 micromètres (courbe 42).

Dans une variante de réalisation, l'inductance est associée à des composants actifs, avantageusement des transistors, destinés à améliorer encore le facteur de qualité de l'inductance.

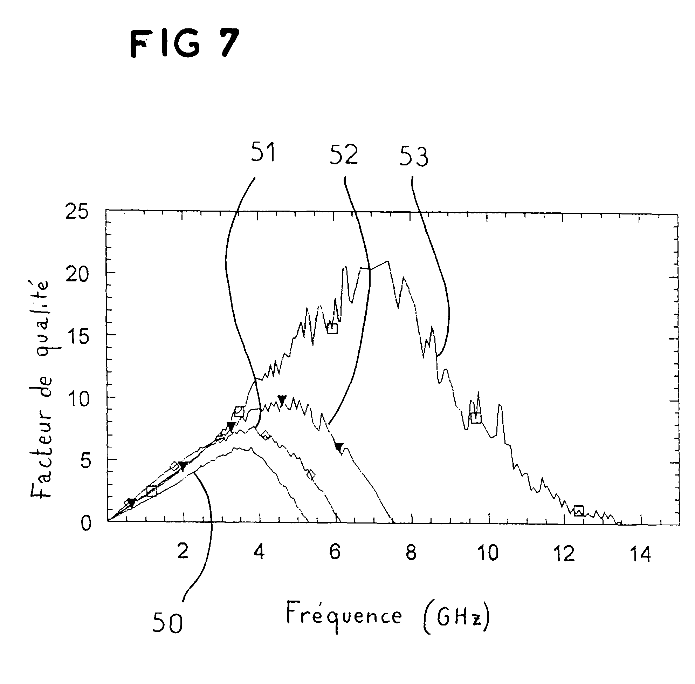

Ces résultats théoriques sont confirmés par les mesures effectuées sur les inductances réelles, comme on le voit à la figure 7. Les inductances correspondent à une spirale de 6 tours d'un ruban de 9 micromètres de large, l'espace entre spires étant de 9 micromètres.

Ainsi, les différentes courbes représentées correspondent à des valeurs d'épaisseur de couches d'air respectivement nulle (courbe 50), de 4 micromètres (courbe 51), de 22 micromètres (courbe 52) et 45 micromètres (courbe 53).

Comme déjà dit, il est également possible de réaliser conformément à l'invention des transformateurs en utilisant deux inductances conformes à l'invention enroulées l'une autour de l'autre.

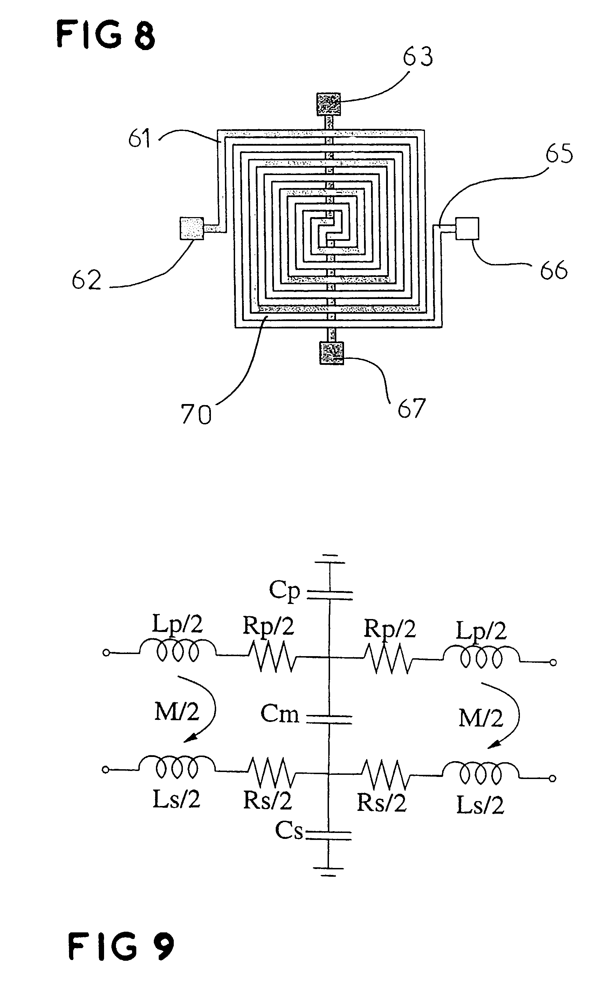

Un exemple de réalisation est montré à la figure 8.

Ainsi le transformateur de la figure 8 comprend une première bobine (61) dont les bornes sont référencées (62, 63), tandis que la seconde bobine (65) présente des bornes référencées (66, 67).

Compte tenu de ce qui a été précisé précédemment pour une inductance simple, le modèle équivalent correspondant au schéma du transformateur est illustré à la figure 9.

Ainsi, l'inductance $L_p$, la résistance $R_p$ et la capacité $C_p$ correspondent aux différents paramètres de l'enroulement primaire (61), tandis que les inductances $L_s$, la résistance $R_s$, et la capacité $C_s$ sont propres à l'enroulement secondaire (65). Les inductances $L_p$ et $L_s$ sont couplées de telle sorte que l'inductance mutuelle correspond à la valeur représentée M.

Comme pour une inductance simple, les différentes spires des inductances (61, 65) en regard, présentent une capacité de couplage entre elles. Cette capacité, représentée de façon globale par la capacité $C_m$ est également réduite conformément à l'invention en réalisant entre les différentes spires des deux inductances (61, 65) couplées, une couche d'air (70) de permittivité électrique beaucoup plus faible que celle d'un substrat qui supporterait la structure du transformateur.

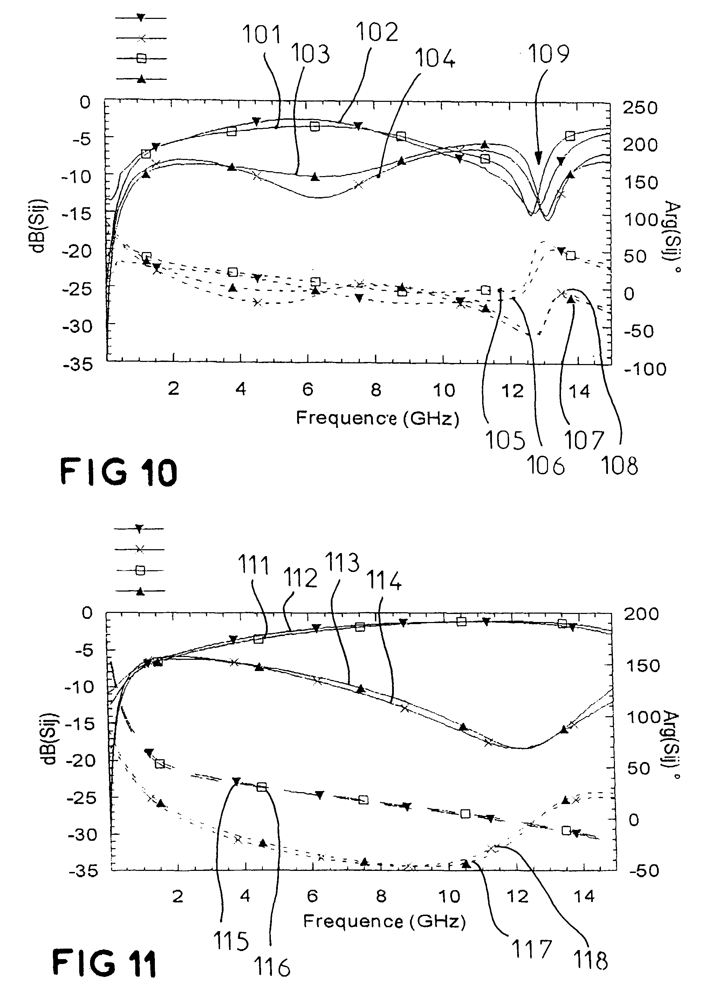

On a représenté en figure 10 et 11 les différentes valeurs, en amplitude (en déciBel) et en phase (en degrés), des paramètres de réflexion et de transmission d'une onde incidente et d'une onde réfléchie, pour une structure particulière correspondant à celle de la figure 9 dans laquelle les paramètres équivalents ont pour valeurs :

- $Cp = Cs = 40\ fF$

- Cm = 200 fF
- Lp = Ls = 8,6 nH
- M = 6,8 nH
- Rp = Rs = 31 $\Omega$

Plus précisément, les différents paramètres représentés sont:

- $S_{11}$ : le coefficient de réflexion de l'onde incidente, lorsque la sortie est chargée par l'impédance caractéristique, égal à $b_1/a_1$ avec $a_2$ nul, compte tenu de la définition des variables $a_1$, $a_2$, $b_1$, $b_2$ ci après.

$$a_1 = \frac{1}{2}\left(\frac{V_{in}}{\sqrt{Z_0}} + \sqrt{Z_0}.I_{in}\right) \qquad a_2 = \frac{1}{2}\left(\frac{V_{out}}{\sqrt{Z_0}} + \sqrt{Z_0}.I_{out}\right)$$

$$b_1 = \frac{1}{2}\left(\frac{V_{in}}{\sqrt{Z_0}} - \sqrt{Z_0}.I_{in}\right) \qquad b_2 = \frac{1}{2}\left(\frac{V_{out}}{\sqrt{Z_0}} - \sqrt{Z_0}.I_{out}\right),$$

dans lesquelles $Z_0$ est l'impédance caractéristique.
- $S_{12}$ : le coefficient de transmission de l'onde réfléchie lorsque l'entrée est chargée par l'impédance caractéristique, égal à $b_1/a_2$ avec $a_1$ nul;
- $S_{21}$ : le coefficient de transmission de l'onde incidente lorsque la sortie est chargée par l'impédance caractéristique, égal à $b_2/a_1$ avec $a_2$ nul;
- $S_{22}$ : le coefficient de réflexion de l'onde réfléchie lorsque l'entrée est chargée par l'impédance caractéristique, égal à $b_2/a_2$ avec $a_1$ nul.

Les figures 10 et 11 représentent chacune deux séries de courbes correspondant aux valeurs des différents coefficients, selon les définitions suivantes:

| N° de courbe | Définition de la courbe |
|---|---|
| 101 | Module théorique de $S_{11}$, inductance reposant sur le substrat |
| 102 | Module mesuré de $S_{11}$, inductance reposant sur le substrat |
| 103 | Module théorique de $S_{21}$, inductance reposant sur le substrat |
| 104 | Module mesuré de $S_{21}$, inductance reposant sur le substrat |
| 105 | Argument théorique de $S_{11}$, inductance reposant sur le substrat |
| 106 | Argument mesuré de $S_{11}$, inductance reposant sur le substrat |
| 107 | Argument théorique de $S_{21}$, inductance reposant sur le substrat |
| 108 | Argument mesuré de $S_{21}$, inductance reposant sur le substrat |
| 111 | Module théorique de $S_{11}$, inductance suspendue sur le substrat |
| 112 | Module mesuré de $S_{11}$, inductance suspendue sur le substrat |
| 113 | Module théorique de $S_{21}$, inductance suspendue sur le substrat |
| 114 | Module mesuré de $S_{21}$, inductance suspendue sur le substrat |
| 115 | Argument théorique de $S_{11}$, inductance suspendue sur le substrat |
| 116 | Argument mesuré de $S_{11}$, inductance suspendue sur le substrat |
| 117 | Argument théorique de $S_{21}$, inductance suspendue sur le substrat |
| 118 | Argument mesuré de $S_{21}$, inductance suspendue sur le substrat |

Ainsi, comme on peut le voir à la figure 10, lorsque la structure du transformateur est directement déposée sur le substrat semi-conducteur, il apparaît aux environs de 12,5 GigaHertz, une fréquence de coupure (109) dont la présence limite la plage de fonctionnement utile du transformateur.

Comme on le voit à la figure 11, une telle fréquence de coupure est inexistante jusqu'à 15 GigaHertz de fréquence, et ceci pour une couche d'air présente sous la structure du transformateur d'une épaisseur de 45 micromètres.

Bien évidemment, l'invention couvre également des variantes dans lesquelles on intègre à l'intérieur de ce transformateur des éléments magnétiques permettant de guider les champs magnétiques, et ainsi d'améliorer le couplage des deux inductances.

L'invention concerne également un procédé permettant d'obtenir de telles inductances et de tels transformateurs. Ainsi, comme déjà dit, ce type de circuit passif peut être réalisé sur des substrats de nature différente, tels que le silicium (SiC) ou préférentiellement l'arséniure de gallium (AsGa) ou encore tout autre type de substrats semi-conducteurs.

Pour réaliser un tel composant on procède de façon traditionnelle, en réalisant, au-dessus d'une couche de substrat, une couche d'oxydation sur laquelle on réalise par métallisation, le bobinage de l'inductance.

Par la suite, on réalise de façon essentielle entre les spires, des ouvertures pour permettre ultérieurement, par gravage, d'éliminer tout substrat présent au niveau des zones inter-spires. Il est essentiel que, pour les raisons précitées, les distances entre spires soient minimales. C'est pourquoi, il convient d'utiliser une technologie appropriée pour réaliser les ouvertures d'aussi faible largeur que possible entre chacune des spires. Ainsi, bien que ces technologies soient accessibles avec de nombreux types de substrats, par exemple le silicium (Si), on pourra avantageusement utiliser l'arséniure de gallium (AsGa) en tant que substrat, avec la technologie de gravage connue sous l'abréviation HEMT précitée.

En effet, dans ce cas il est possible de réaliser des ouvertures d'une largeur de l'ordre de 4 micromètres, ce qui permet d'obtenir une compacité inégalée pour des inductances ou des transformateurs intégrés.

Il ressort de ce qui précède que les inductances et les transformateurs conforment à l'invention présentent un facteur de qualité nettement supérieur à ceux des composants passifs connus existants, grâce à une diminution notable des capacités parasites entre spires. Ceci permet leur intégration dans des composants de taille moindre, et fonctionnant à des fréquences plus élevées.

**Revendications**

1. Circuit intégré monolithique, notamment destiné à être incorporé dans un circuit de radio-fréquence, comprenant :

   - une couche de substrat (6) en matériau semi-conducteur ;
   - une inductance plane (1) formée d'un ruban métallique enroulé en spirale,

   <u>caractérisé</u> en ce que chaque spire (2 - 5) de l'inductance (1) est séparée :

   - des spires voisines par une couche d'air (10) ;
   - et de la couche de substrat par une couche d'air (15).

2. Circuit intégré selon la revendication 1, <u>caractérisé</u> en ce que le ruban métallique (1) enroulé en spirale est constitué d'une succession de segments rectilignes (2 - 5)

3. Circuit intégré selon la revendication 1 ou 2, <u>caractérisé</u> en ce que chaque spire est éloignée des spires voisines d'une distance inférieure à 15 micromètres.

4. Circuit intégré selon les revendications 1 à 3, <u>caractérisé</u> en ce que le substrat est réalisé en silicium (Si), en arséniure de gallium (AsGa), en carbure de silicium (SiC) ou en phosphure d'indium (InP).

5. Circuit intégré selon l'une des revendications 1 à 4, <u>caractérisé</u> en ce que l'inductance (1) repose sur deux poutres (16, 17) de matériau semi-conducteur traversant une cavité (15) creusée dans la couche de substrat (6).

6. Circuit intégré selon l'une des revendications 1 à 6, <u>caractérisé</u> en ce qu'il comprend une seconde inductance plane (65) enroulée en spirale entre les spires de la première inductance (61), de manière à ce que les deux inductances soient couplées pour former un transformateur, les spires des deux inductances étant séparées les unes des autres par une couche d'air (70).

**7.** Procédé pour réaliser un circuit intégré selon les revendications 1 à 6, <u>caractérisé</u> en ce qu'il consiste :

- à former sur un substrat semi-conducteur, une couche d'oxydation ;
- à déposer une couche de métallisation sur ladite couche d'oxydation pour former au moins un ruban en spirale destiné à constituer une inductance ;
- à réaliser des ouvertures dans la couche d'oxydation entre les spires du ruban ;
- à graver le substrat dans lesdites zones d'ouvertures par attaque chimique de manière à réaliser une cavité sous le ruban en spirale, et à isoler les spires du ruban les unes des autres.

# FIG 1

# FIG 2

FIG 3

FIG 4

# FIG 5

# FIG 6

# FIG 7

# FIG 8

# FIG 9

FIG 10

FIG 11

**Office européen des brevets**

**RAPPORT DE RECHERCHE EUROPEENNE**

Numéro de la demande

EP 99 42 0135

## DOCUMENTS CONSIDERES COMME PERTINENTS

| Catégorie | Citation du document avec indication, en cas de besoin, des parties pertinentes | Revendication concernée | CLASSEMENT DE LA DEMANDE |
|---|---|---|---|
| D,X | WO 94 17558 A (UNIV CALIFORNIA) 4 août 1994 (1994-08-04) | 1,2 | H01L23/64 H01L23/66 |
| A | * revendications 1,2,7,10-13,19; figure 2 * | 5,6 | |
| Y | EP 0 782 190 A (NIPPON ELECTRIC CO) 2 juillet 1997 (1997-07-02) | 1 | |
| A | * page 6, ligne 29 - ligne 31; revendications 1,10; figures 6A,6B * | 2-4,7 | |
| Y | PATENT ABSTRACTS OF JAPAN vol. 096, no. 012, 26 décembre 1996 (1996-12-26) & JP 08 222694 A (TOSHIBA CORP), 30 août 1996 (1996-08-30) * abrégé * | 1 | |
| A | EP 0 809 289 A (HARRIS CORP) 26 novembre 1997 (1997-11-26) * colonne 3, ligne 8 - ligne 31; revendications 1,6; figure 1 * | 1,4,7 | **DOMAINES TECHNIQUES RECHERCHES** |
| A | EP 0 523 450 A (SUMITOMO ELECTRIC INDUSTRIES) 20 janvier 1993 (1993-01-20) * colonne 3, ligne 35 - ligne 38; revendications 1,3; figure 1 * | 1,2,4 | H01L |
| A | PATENT ABSTRACTS OF JAPAN vol. 097, no. 006, 30 juin 1997 (1997-06-30) & JP 09 036312 A (NEC CORP), 7 février 1997 (1997-02-07) * abrégé * | 1 | |

-/--

Le présent rapport a été établi pour toutes les revendications

| Lieu de la recherche | Date d'achèvement de la recherche | Examinateur |
|---|---|---|
| LA HAYE | 18 août 1999 | De Raeve, R |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**Office européen des brevets**

# RAPPORT DE RECHERCHE EUROPEENNE

Numéro de la demande

EP 99 42 0135

## DOCUMENTS CONSIDERES COMME PERTINENTS

| Catégorie | Citation du document avec indication, en cas de besoin, des parties pertinentes | Revendication concernée | CLASSEMENT DE LA DEMANDE |
|-----------|-------------------------------------------------------------------|------------------|-------------------|
| A | PATENT ABSTRACTS OF JAPAN<br>vol. 017, no. 101 (E-1327),<br>2 mars 1993 (1993-03-02)<br>& JP 04 290212 A (MURATA MFG CO LTD),<br>14 octobre 1992 (1992-10-14)<br>* abrégé *<br>--- | 1 | |
| A | PATENT ABSTRACTS OF JAPAN<br>vol. 097, no. 007,<br>31 juillet 1997 (1997-07-31)<br>& JP 09 063847 A (NEC CORP),<br>7 mars 1997 (1997-03-07)<br>* abrégé *<br>----- | 1 | |

**DOMAINES TECHNIQUES RECHERCHES**

Le présent rapport a été établi pour toutes les revendications

| Lieu de la recherche | Date d'achèvement de la recherche | Examinateur |
|----------------------|-----------------------------------|-------------|
| LA HAYE | 18 août 1999 | De Raeve, R |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépot ou après cette date
D : cité dans la demande
L : cité pour d'autres raisons

& : membre de la même famille, document correspondant

EPO FORM 1503 03.82 (P04C02)

# EP 0 969 509 A1

**ANNEXE AU RAPPORT DE RECHERCHE EUROPEENNE
RELATIF A LA DEMANDE DE BREVET EUROPEEN NO.**    EP 99 42 0135

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

18-08-1999

| Document brevet cité au rapport de recherche | | Date de publication | Membre(s) de la famille de brevet(s) | | Date de publication |
|---|---|---|---|---|---|
| WO 9417558 | A | 04-08-1994 | US | 5539241 A | 23-07-1996 |
| EP 0782190 | A | 02-07-1997 | JP | 9181264 A | 11-07-1997 |
| JP 08222694 | A | 30-08-1996 | AUCUN | | |
| EP 0809289 | A | 26-11-1997 | US | 5825092 A | 20-10-1998 |
| | | | CN | 1170961 A | 21-01-1998 |
| | | | JP | 10107201 A | 24-04-1998 |
| EP 0523450 | A | 20-01-1993 | JP | 5013234 A | 22-01-1993 |
| | | | JP | 5013235 A | 22-01-1993 |
| | | | CA | 2072277 A | 04-01-1993 |
| | | | US | 5396101 A | 07-03-1995 |
| JP 09036312 | A | 07-02-1997 | US | 5874883 A | 23-02-1999 |
| JP 04290212 | A | 14-10-1992 | AUCUN | | |
| JP 09063847 | A | 07-03-1997 | AUCUN | | |

EPO FORM P0460

Pour tout renseignement concernant cette annexe : voir Journal Officiel de l'Office européen des brevets, No.12/82